# EUROPEAN PATENT APPLICATION

(11) **EP 2 824 550 A2**
(43) Date of publication of application: **14.01.2015**
(21) Application number: 14176180.9
(22) Date of filing: 08.07.2014
(51) Int. Cl.: G06F 3/044

(54) **Touch sensing component and method for manufacturing the same, touch screen and electronic device**

(30) Priority: 08.07.2013 CN 201310284545; 25.02.2014 US 201414189298
(71) Applicant: Sony Corporation, Tokyo 108-0075 (JP)
(72) Inventor: Tian, Xiyong, 100102 Beijing (CN)
(74) Representative: Banzer, Hans-Jörg

(57) **Abstract**

The embodiments of the present invention provide a touch sensing component and a method for manufacturing the same, a touch screen and an electronic device. The touch sensing component comprises a base layer (301) which serves as a carrier of Indium Tin Oxide (ITO); and an ITO layer (302) provided on the base layer (301); the ITO layer (302) being divided into two or more portions (3021, 3022) in a direction parallel with the base layer, and the two or more portions (3021, 3022) being staggered in a direction perpendicular to the base layer. In the embodiments of the present invention, the boarder size of the electronic device can be further reduced, and a larger effective display or control area can be obtained.

## Description

### Technical Field

The present invention relates to touch sensing technologies, and particularly, to a touch sensing component and a method for manufacturing the same, a touch screen and an electronic device.

### Background

With the development of technologies, at present electronic devices, such as a mobile terminal and a tablet PC, widely use the touch screen as an input device. The touch screen mainly includes a substrate, a touch detection component and a touch screen controller. Based on the working principle of the touch screen and the medium for information transmission, the touch screen may be classified into resistive touch screen, capacitive touch screen, etc.

The resistive touch screen is a multilayer composite film which performs a resistance control by utilizing pressure sensing. The basic principle of the capacitive touch screen is to work by utilizing current sensing of the human body; the touch screen may be a two-layered glass screen, and a conductive component is formed by covering Indium Tin Oxide (ITO) on the surface of the sensing substrate layer. Since the substrate and the base are made of different materials, there are various combinations of practices and processes.

Currently, the display screen of the electronic device such as the terminal becomes increasingly larger, and in order to acquire an effective display area or control area, the user hopes to reduce the frame size so far as possible. However, due to the influence from the manufacturing process, it is more and more difficult to further reduce the frame size of the electronic device.

To be noted, the above introduction to the technical background is just made for the convenience of clearly and completely describing the technical solutions of the present invention, and to facilitate the understanding of a person skilled in the art. It shall not be deemed that the above technical solutions are known to a person skilled in the art just because they have been illustrated in the Background section of the present invention.

### Summary

The object is to further reduce the boarder size of the electronic device by changing the touch sensing structure. The embodiments of the present invention provide a touch sensing component as defined in claim 1 and a method for manufacturing the same as defined in claim 11 as well as a corresponding touch screen and an electronic device. The dependent claims define preferred and/or advantageous embodiments of the invention.

According to an aspect of the embodiments of the present invention, a touch sensing component is provided, including:
a base layer which serves as a carrier of Indium Tin Oxide (ITO); and
an ITO layer provided on the base layer; the ITO layer being divided into two or more portions in a direction parallel with the base layer, and the two or more portions being staggered in a direction perpendicular to the base layer.

According to another aspect of the embodiments of the present invention, wherein the two or more portions are located in different planes in the direction parallel with the base layer.

According to another aspect of the embodiments of the present invention, wherein the ITO layer includes a first ITO layer provided on one surface of the base layer, and a second ITO layer provided on the other surface of the base layer;
and, the first ITO layer is provided on a part of the one surface of the base layer, and the second ITO layer is provided on a part of the other surface of the base layer, so that the first ITO layer and the second ITO layer are staggered in the direction perpendicular to the base layer.

According to another aspect of the embodiments of the present invention, wherein the base layer includes a first base layer and a second base layer, and the ITO layer includes a first ITO layer provided on the first base layer and a second ITO layer provided on the second base layer;
and, the first ITO layer is provided on a part of the first base layer, and the second ITO layer is provided on a part of the second base layer, so that the first ITO layer and the second ITO layer are staggered in the direction perpendicular to the base layer.

According to another aspect of the embodiments of the present invention, wherein the first base layer is provided on the second base layer.

According to another aspect of the embodiments of the present invention, wherein the touch sensing component further including:
a substrate layer provided on the first ITO layer.

According to another aspect of the embodiments of the present invention, wherein the touch sensing component further including:
a third base layer provided on the first ITO layer; and
a third ITO layer provided on the third base layer.

According to another aspect of the embodiments of the present invention, wherein the touch sensing component further including:
a substrate layer provided on the third ITO layer.

According to another aspect of the embodiments of the present invention, a touch screen is provided, including the aforementioned touch sensing component.

According to another aspect of the embodiments of the present invention, an electronic device is provided, including the aforementioned touch screen.

According to another aspect of the embodiments of the present invention, a method for manufacturing a touch sensing component, including:
forming a base layer which serves as a carrier of ITO; and
providing an ITO layer on the base layer; the ITO layer being divided into two or more portions in a direction parallel with the base layer, and the two or more portions being staggered in a direction perpendicular to the base layer.

According to another aspect of the embodiments of the present invention, wherein the method further including:
providing a substrate layer on the ITO layer.

The embodiments of the present invention have the following beneficial effect: by staggering the ITO layer into two or more portions, the border size of the electronic device can be further reduced, and a larger effective display or control area can be obtained.

These and other aspects of the present invention will be clear with reference to the following descriptions and drawings. In those descriptions and drawings, the specific embodiments of the present invention are concretely disclosed to represent the principle of the present invention and some implementations. But it shall be appreciated that the scope of the present invention is not limited thereto. On the contrary, the present invention includes all changes, modifications and equivalents falling within the scope of the spirit and the connotation of the accompanied claims.

Features described and/or illustrated with respect to one embodiment can be used in one or more other embodiments in a same or similar way, and/or combine with or replace the features in other embodiments.

To be noted, the term "comprise/include" used herein specifies the presence of feature, integer, step or component, not excluding the presence or addition of one or more other features, integers, steps or components.

Many aspects of the present invention can be understood better with reference to the following drawings. The components in the drawings are not surely drafted in proportion, and the emphasis lies in clearly illustrating the principle of the present invention. For the convenience of illustrating and describing some portions of the present invention, corresponding portions in the drawings may be enlarged, e.g., being enlarged in relation to other portions in an exemplary device practically manufactured according to the present invention. The parts and features described in one drawing or embodiment of the present invention may be combined with the parts and features illustrated in one or more other drawings or embodiments. In addition, the same reference signs denote corresponding portions throughout the drawings, and they can be used to denote the same or similar portions in more than one embodiment.

### Brief Description of the Drawings

The included drawings are provided for further understanding of the present invention, and they constitute a part of the Specification. The drawings illustrate the preferred embodiments of the present invention, and they are used to explain the principle of the present invention together with the text, wherein the same element is always denoted with the same reference sign.

In which:
Fig. 1 is a schematic diagram of an ITO pattern in the prior art;
Fig. 2 is a schematic diagram of an edge size in a technology of the existing film base touch sensing component;
Fig. 3 is a schematic cross-section view of a touch sensing component according to an embodiment of the present invention;
Fig. **4** is a schematic diagram of a touch sensing component in the prior art;
Fig. 5 is a schematic cross-section view along line XX' in Fig. **4****;**
Fig. 6 is a schematic cross-section view along line YY' in Fig. **4****;**
Fig. 7 is a schematic diagram of a touch sensing component according to an embodiment of the present invention;
Fig. 8 is a schematic cross-section view along line AA' in Fig. 7;
Fig. 9 is a schematic cross-section view along line BB' in Fig. 7;
Fig. 10 is a schematic diagram of a touch sensing component according to an embodiment of the present invention;
Fig. 11 is a schematic cross-section view along line CC' in Fig. 10;
Fig. 12 is a schematic cross-section view along line DD' in Fig. 10;
Fig. 13 is another schematic diagram of a touch sensing component in the prior art;
Fig. 14 is a schematic cross-section view along line XX' in Fig. 13;
Fig. 15 is a schematic cross-section view along line YY' in Fig. 13;
Fig. 16 is a schematic diagram of a touch sensing component according to an embodiment of the present invention;
Fig. 17 is a schematic cross-section view along line EE' in Fig. 16;
Fig. 18 is a schematic cross-section view along line FF' in Fig. 16;
Fig. 19 is a schematic diagram of a touch sensing component according to an embodiment of the present invention;
Fig. 20 is a schematic cross-section view along line GG' in Fig. 19;
Fig. 21 is a schematic cross-section view along line HH' in Fig. 19;
Fig. 22 is a flowchart of a method for manufacturing a touch sensing component according to an embodiment of the present invention; and
Fig. 23 is a schematic block diagram of a system structure of a mobile terminal according to an embodiment of the present invention.

### Description of the Embodiments

The interchangeable terms "electronic device" and "electronic apparatus" include a portable radio communication device. The term "portable radio communication device", which is hereinafter referred to as "mobile radio terminal", "portable electronic apparatus", or "portable communication apparatus", including all devices such as mobile phone, pager, communication apparatus, electronic organizer, personal digital assistant (PDA), smart phone, portable communication apparatus or the like.

In the present application, the embodiments are mainly described with respect to a portable electronic apparatus in the form of a mobile phone (also referred to as "cellular phone"). However, it shall be appreciated that the present invention is not limited to the case of the mobile phone and it may relate to any type of appropriate electronic device, such as media player, gaming device, PDA, computer, digital camera, tablet PC, etc.

Currently, the touch sensing component of the touch screen is generally a sensing matrix formed by a plurality of staggered row electrodes and column electrodes. The normal design includes: providing the row electrodes and the column electrodes on two sides of the same base, respectively, to prevent any short-circuit occurring at intersected positions; or providing the row electrodes and the column electrodes on the same side of the same base, while isolating the row electrodes and the column electrodes from each other and ensuring they are conducted in their own directions, by arranging insulation layers and building conductive bridges at the intersected positions of the row electrodes and the column electrodes.

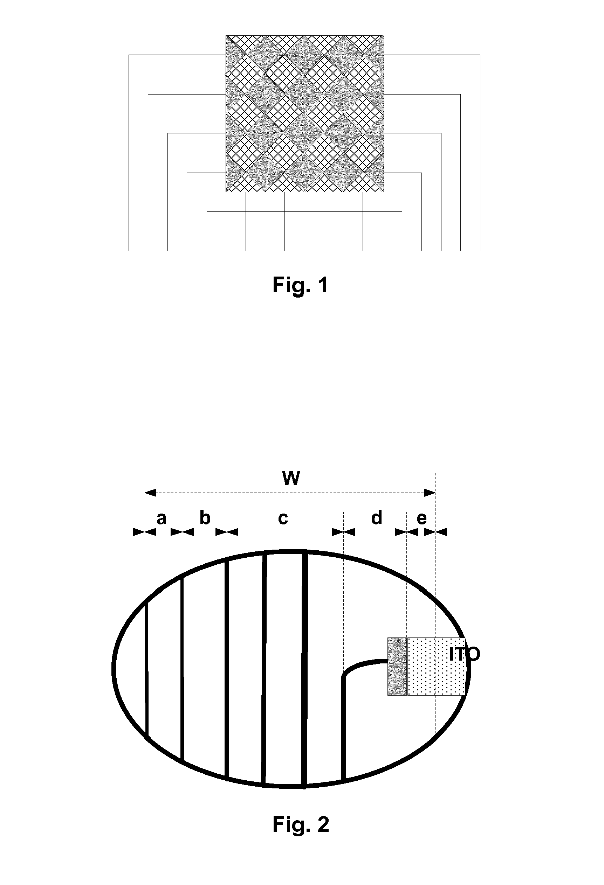

Fig. 1 is a schematic diagram of an ITO pattern in the prior art. As illustrated in Fig. 1, the row electrodes and the column electrodes may be staggered to form a diamond-shaped structure. As illustrated in Fig. 1, the signals may be transmitted through touch signal lines.

On the other hand, the touch screen of the electronic device has a horizontal direction and a perpendicular direction, where the horizontal direction may be divided into two directions (e.g., direction X and direction Y), and the perpendicular direction may be called as direction Z. Due to the limitation of the manufacturing process, currently the edge size (including those in direction X and direction Y) of the electronic device is influenced by multiple factors.

Fig. 2 is a schematic diagram of an edge size in a technology of the existing film base touch sensing component, and direction X is taken as an example. As illustrated in Fig. 2, the edge size of the electronic device in direction X is W=a + b + c + d + e. Where a is a distance between a window panel and the edge of the touch sensing component, for example a=0.2mm; b is a distance between the edge of the touch sensing component and an ITO lead, for example b=0.35mm; c is protection lead width and lead spacing of a width occupied by a plurality of ITO leads, c=2 (n-1) × 0.05mm, where n is the number of the leads, 0.05mm is a lead width or lead spacing; d is a width from an innermost ITO lead to an outermost ITO edge, for example d=0.65mm; and e is a width from the outermost ITO edge to an inner print frame of the window panel, for example e=0.45mm.

However, presently a, b, d and e are small and then difficult to be further reduced, while in the prior art for example n=24/2. Thus W=0.2 + 0.35 + 2 (24/2-1) × 0.05 + 0.65 + 0.45 = 2.75mm. The inventor finds that n may be varied by changing the structure of the ITO layer, thereby achieving the purpose of reducing the edge size. Next, descriptions will be made through specific embodiments.

### Embodiment 1

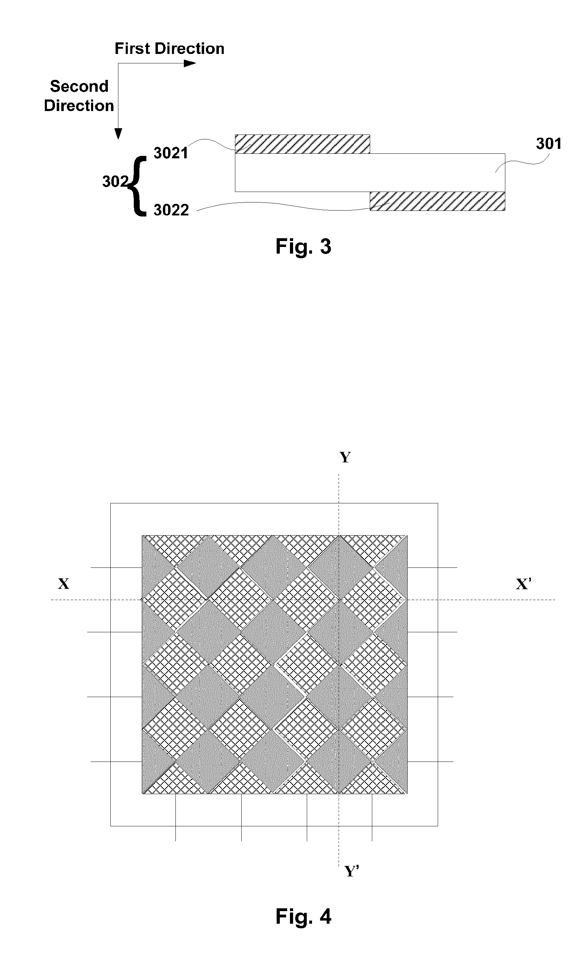

The embodiment of the present invention provides a touch sensing component, and Fig. 3 is a schematic cross-section view of a touch sensing component according to an embodiment of the present invention. As illustrated in Fig. 3, the touch sensing component includes:
a base layer 301 which serves as a carrier of ITO;
an ITO layer 302 provided on the base layer 301; the ITO layer 302 being divided into two or more portions in a direction parallel with the base layer 301, and the two or more portions being staggered in a direction perpendicular to the base layer 301.

In this embodiment, the base layer 301 may be made of a material such as film or glass, but the present invention is not limited thereto, and other material may also be used according to actual conditions.

In this embodiment, descriptions are made by using an example where the ITO layer 302 is divided into two portions. The ITO layer 302 may be divided into two portions 3021 and 3022 in different planes in a first direction (e.g., direction Y) parallel with the base layer 301. In addition, the two portions 3021 and 3022 are staggered in a second direction (e.g., direction Z) perpendicular to the base layer 301. For example, in the second direction, the projections of the portions 3021 and 3022 of the ITO layer do not coincide on the same plane.

As illustrated in Fig. 3, one portion 3021 of the ITO layer 302 may be provided on one surface of the base layer 301; the other portion 3022 of the ITO layer 302 may be provided on the other surface of the base layer 301; and the portions 3021 and 3022 of the ITO layer 302 may be provided on two ends of the base layer 301, respectively. But the present invention is not limited thereto, and two or more base layers may also be used for the arrangement, please refer to the after-mentioned embodiments.

Thus n may be varied by changing the structure of the ITO layer. In the ITO component as illustrated in Fig. 3, n=24/4. As a result, the edge size of an electronic device using the ITO component is W=0.2 + 0.35 + 2 (24/4-1) ×0.05 + 0.65 + 0.45 = 2.15mm. Therefore, relative to the electronic device in the prior art, an electronic device of smaller edge size can be obtained.

In this embodiment, the first direction may be either direction Y or direction X. Thus, the edge size in either direction Y or direction X can be reduced in the embodiment of the present invention, thereby meeting the requirements of many electronic devices (e.g., mobile terminal, tablet PC, etc.).

To be noted, Fig. 3 only illustrates an example where the ITO layer is divided into two portions. But the present invention is not limited thereto, and for example a structure of more than two layers may also be used. As to the connection between the signal lines of the two portions, please refer to the prior art for the details.

As can be seen from the above embodiment, by staggering the ITO layer into two or more portions, the border size of the electronic device can be further reduced, and a larger effective display or control area can be obtained.

### Embodiment 2

The embodiment of the present invention provides a touch sensing component, and the present invention is further described based on Embodiment 1.

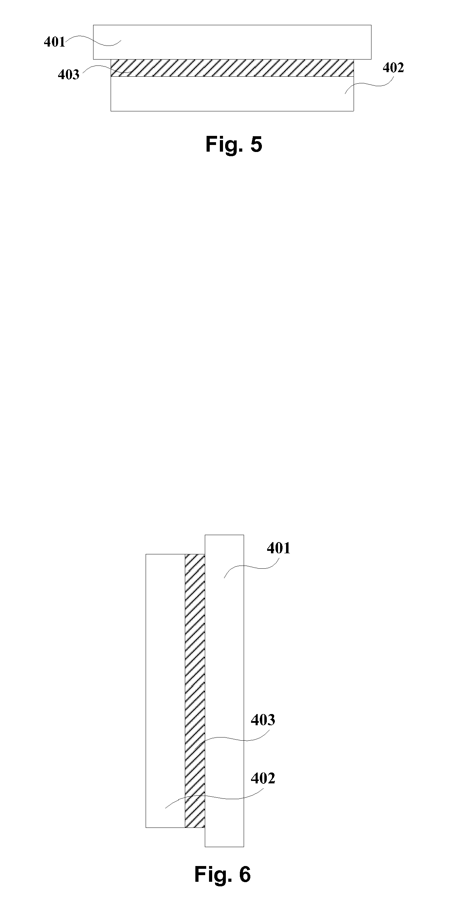

The Glass plus Glass (GG) solution is taken as an example, Fig. 4 is a schematic diagram of a touch sensing component in the prior art, Fig. 5 is a schematic cross-section view along line XX' in Fig. 4, and Fig. 6 is a schematic cross-section view along line YY' in Fig. 4. As illustrated in Figs. 4 to 6, in a structure of the GG solution in the prior art, the touch sensing component includes a substrate layer 401, a base layer 402 and an ITO layer 403, where the ITO layer 403 is provided on the base layer 402, and the substrate layer 401 is provided on the ITO layer 403.

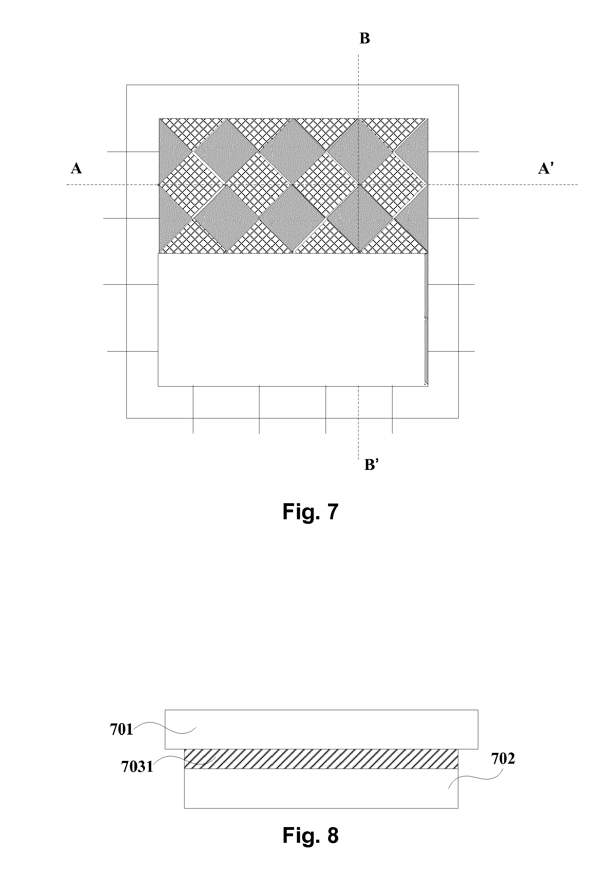

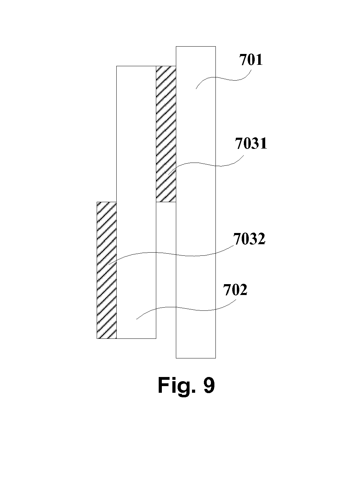

Differently, in one embodiment, Fig. 7 is a schematic diagram of a touch sensing component according to an embodiment of the present invention, Fig. 8 is a schematic cross-section view along line AA' in Fig. 7, and Fig. 9 is a schematic cross-section view along line BB' in Fig. 7.

As illustrated in Figs. 7 to 9, the touch sensing component includes a substrate layer 701, a base layer 702 and an ITO layer, where the ITO layer includes a first ITO layer 7031 provided on one surface of the base layer 701, and a second ITO layer 7032 provided on the other surface of the base layer 702; and the substrate layer 701 is provided on the first ITO layer 7031.

In this embodiment, the substrate layer 701 may be made of toughened glass or transparent plastic, but the present invention is not limited thereto, for example other transparent material may also be used according to actual conditions.

As illustrated in Figs. 7 to 9, the first ITO layer 7031 is provided on a part of one surface 702A of the base layer 702 in a first direction (e.g., direction Y parallel with the base layer), and the second ITO layer 7032 is provided on a part of the other surface 702B of the base layer 702 in the first direction, so that the first ITO layer 7031 and the second ITO layer 7032 are staggered in a second direction (e.g., direction Z perpendicular to the base layer).

Thus in this embodiment, the ITO layer may be divided into two portions which are located in different planes in a direction parallel with the base layer, and staggered at two surfaces of the base layer in a direction perpendicular to the base layer. Therefore, n can be varied by changing the structure of the ITO layer, thereby obtaining an electronic device of smaller edge size.

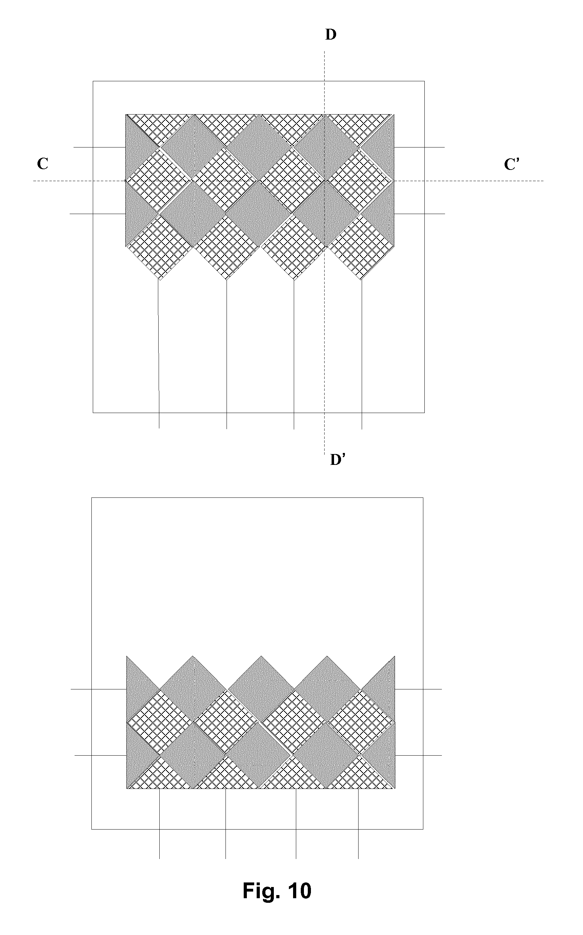

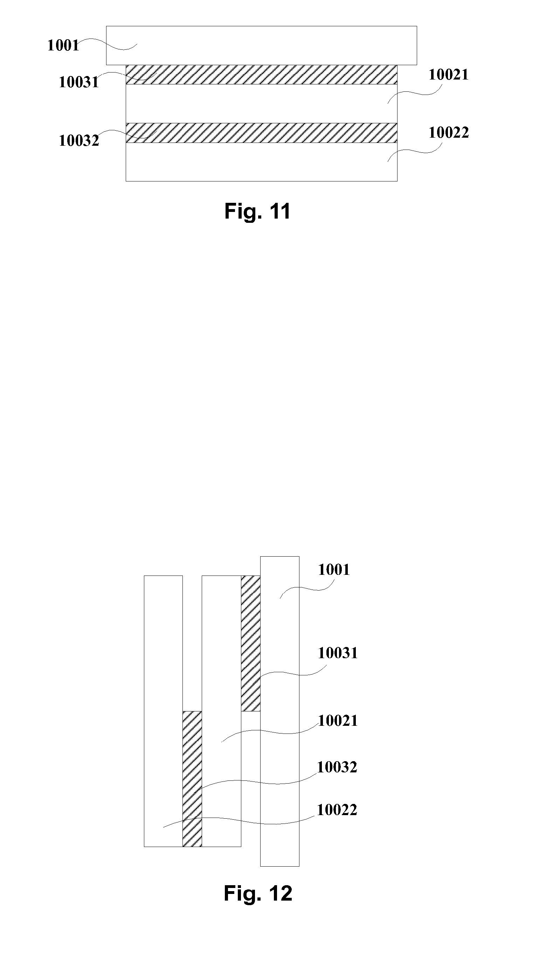

In another embodiment, the GG solution is taken as an example, Fig. 10 is a schematic diagram of a touch sensing component according to an embodiment of the present invention, where two layers of the touch sensing component are illustrated, Fig. 11 is a schematic cross-section view along line CC' in Fig. 10, and Fig. 12 is a schematic cross-section view along line DD' in Fig. 10.

As illustrated in Figs. 10 to 12, the touch sensing component includes a substrate layer 1001, a base layer and an ITO layer, where the base layer includes a first base layer 10021 and a second base layer 10022; the ITO layer includes a first ITO layer 10031 provided on the first base layer 10021 and a second ITO layer 10032 provided on the second base layer 10022; and the substrate layer 1001 is provided on the first ITO layer 10031.

As illustrated in Figs. 10 to 12, the first ITO layer 10031 is provided on a part of the first base layer 10021 in the first direction (e.g., direction Y), and the second ITO layer 10032 is provided on a part of the second base layer 10022 in the first direction, so that the first ITO layer 10031 and the second ITO layer 10032 are staggered in the second direction (e.g., direction Z).

Thus in this embodiment, the ITO layer may be divided into two portions which are provided on two base layers, respectively. In addition, the two portions are located in different planes in the direction parallel with the base layers, and staggered in the direction perpendicular to the base layers. Therefore, n can be varied by changing the structure of the ITO layer, thereby obtaining an electronic device of smaller edge size.

To be noted, the present invention is described as above just by taking the GG solution as an example, but the present invention is not limited thereto, for example it may also be applied to the structures such as glass plus film (GF2) and glass plus film (G1F1). Next, the present invention will be detailedly described by using an example of glass plus two layers of ITO films (GFF).

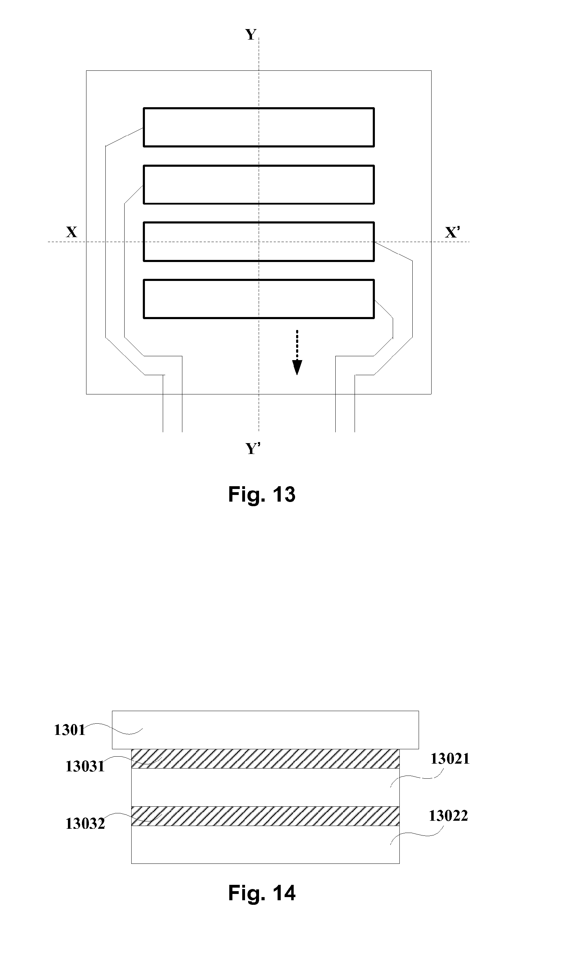

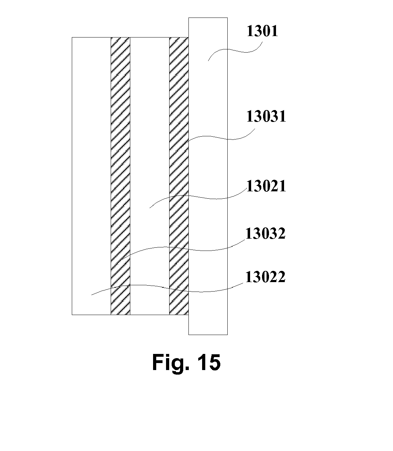

In the example of glass plus two layers of ITO films (GFF), Fig. 13 is another schematic diagram of a touch sensing component in the prior art, Fig. 14 is a schematic cross-section view along line XX' in Fig. 13, and Fig. 15 is a schematic cross-section view along line YY' in Fig. 13. As illustrated in Figs. 13 to 15, in the GFF structure of the prior art, the touch sensing component includes a substrate layer 1301, a base layer 13021 and an ITO layer 13031 in direction Y, a base layer 13022 and an ITO layer 13032 in direction X, where the ITO layer 13031 is provided on the base layer 13021 in direction Y, the ITO layer 13032 is provided on the base layer 13022 in direction X, and the substrate layer 1301 is provided on the ITO layer 13031.

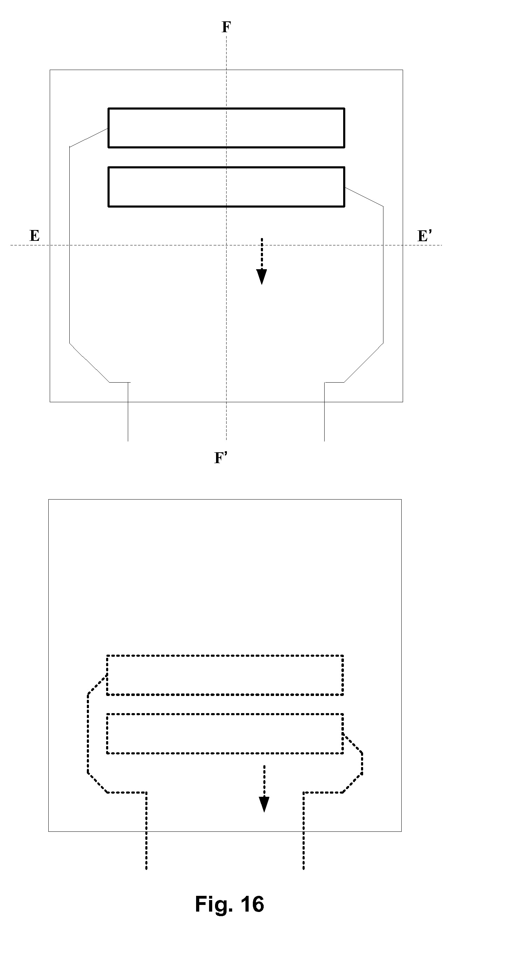

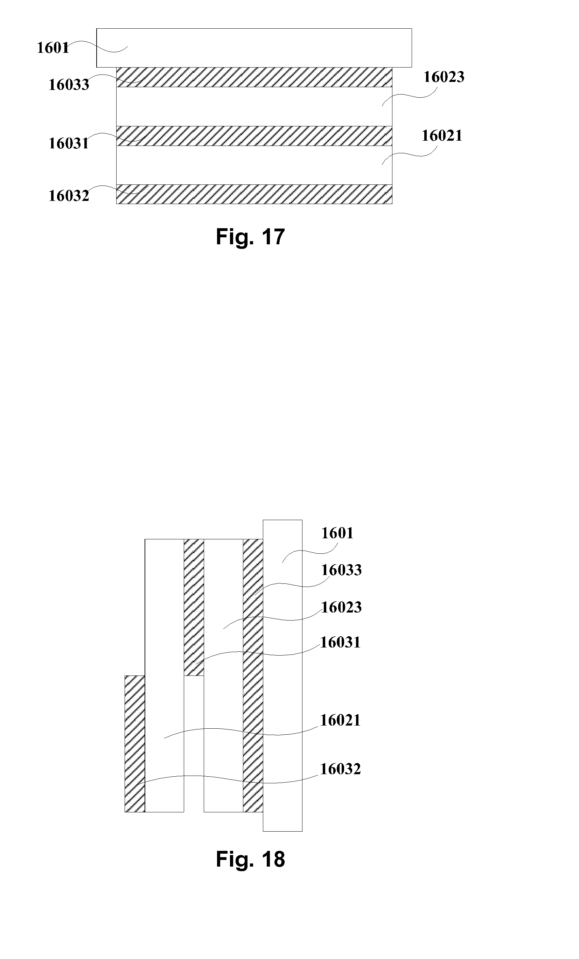

Differently, in another embodiment, Fig. 16 is a schematic diagram of a touch sensing component according to an embodiment of the present invention, wherein two layers of the touch sensing component are illustrated, Fig. 17 is a schematic cross-section view along line EE' in Fig. 16, and Fig. 18 is a schematic cross-section view along line FF' in Fig. 16.

As illustrated in Figs. 16 to 18, the touch sensing component includes a substrate layer 1601, a first base layer 16021 (i.e., a base layer in direction X), a first ITO layer 16031 provided on one surface of the first base layer 16021, and a second ITO layer 16032 provided on the other surface of the first base layer 16021. In addition, as illustrated in Figs. 16 to 18, the touch sensing component further includes a third base layer 16023 (i.e., a base layer in direction Y) and a third ITO layer 16033 provided thereon.

As illustrated in Figs. 16 to 18, the first ITO layer 16031 is provided on a part of one surface of the first base layer 16021 in a first direction (e.g., direction Y), and the second ITO layer 16032 is provided on a part of the other surface of the first base layer 16021 in the first direction, so that the first ITO layer 16031 and the second ITO layer 16032 are staggered in a second direction (e.g., direction Z).

Thus in this embodiment, the ITO layer in direction X may be divided into two portions which are located in different planes in the direction parallel with the base layer, and staggered at two surfaces of the base layer in direction X in the direction perpendicular to the base layer. Therefore, n can be varied by changing the structure of the ITO layer, thereby obtaining an electronic device of smaller edge size. To be noted, the present invention may also vary the edge size in direction Y by changing the ITO layer in direction Y, and the embodiment may be determined according to actual conditions.

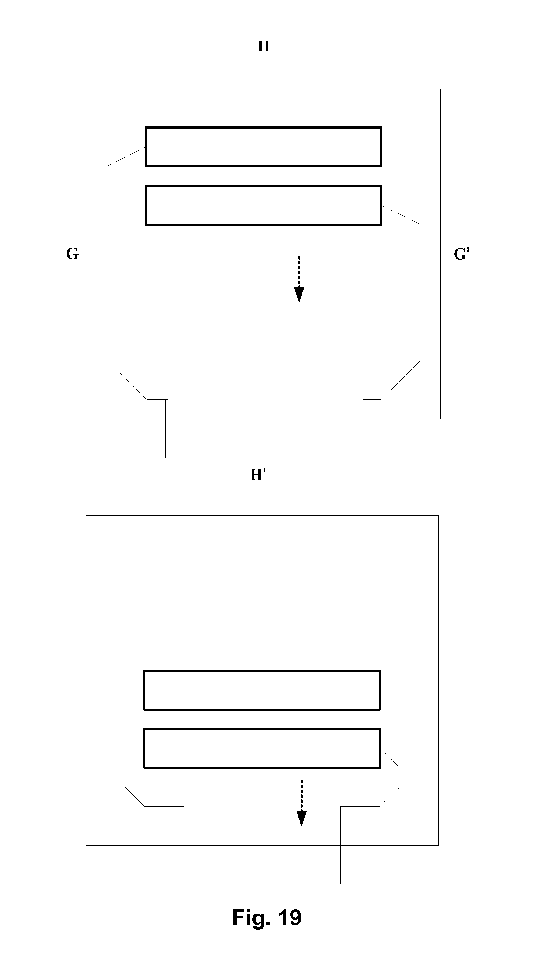

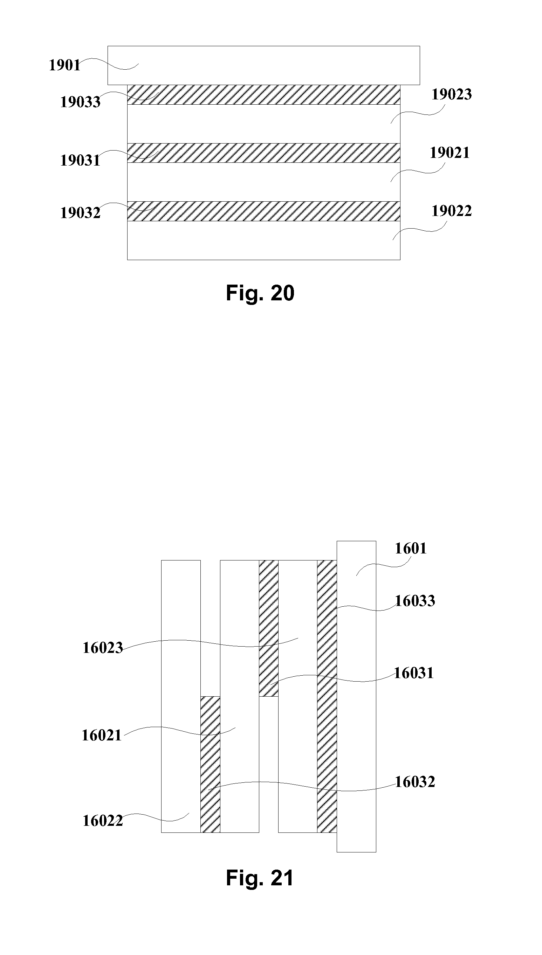

In another embodiment, glass plus two layers of ITO films (GFF) is still taken as an example, Fig. 19 is a schematic diagram of a touch sensing component according to an embodiment of the present invention, where two layers of the touch sensing component are illustrated, Fig. 20 is a schematic cross-section view along line GG' in Fig. 19, and Fig. 21 is a schematic cross-section view along line HH' in Fig. 19.

As illustrated in Figs. 19 to 21, the touch sensing component includes a substrate layer 1901, a first base layer 19021 (e.g., a base layer in direction X), a second base layer 19022 (e.g., a base layer in direction X), a first ITO layer 19031 provided on the first base layer 19021, and a second ITO layer 19032 provided on the second base layer 19022. In addition, as illustrated in Figs. 19 to 21, the touch sensing component further includes a third base layer 19023 (i.e., a base layer in direction Y) and a third ITO layer 19033 provided thereon.

As illustrated in Figs. 19 to 21, the first ITO layer 19031 is provided on a part of the first base layer 19021 in a first direction (e.g., direction Y), and the second ITO layer 19032 is provided on a part of the second base layer 19022 in the first direction, so that the first ITO layer 19031 and the second ITO layer 19032 are staggered in a second direction (e.g., direction Z).

Thus in this embodiment, the ITO layer in direction X may be divided into two portions which are provided on two base layers in direction X, respectively. In addition, the two portions are located in different planes in the direction parallel with the base layers, and staggered in the direction perpendicular to the base layers. Therefore, n can be varied by changing the structure of the ITO layer, thereby obtaining an electronic device of smaller edge size. To be noted, the edge size in direction Y may also be varied by changing the ITO layer in direction Y, and the embodiment may be determined according to actual conditions.

As can be seen from the above embodiment, by staggering the ITO layer into two or more portions, the border size of the electronic device can be further reduced, and a larger effective display or control area can be obtained.

### Embodiment 3

The embodiment of the present invention provides a method for manufacturing a touch sensing component, and the touch sensing component formed in the method for manufacturing may be as illustrated in Fig. 1 or 2.

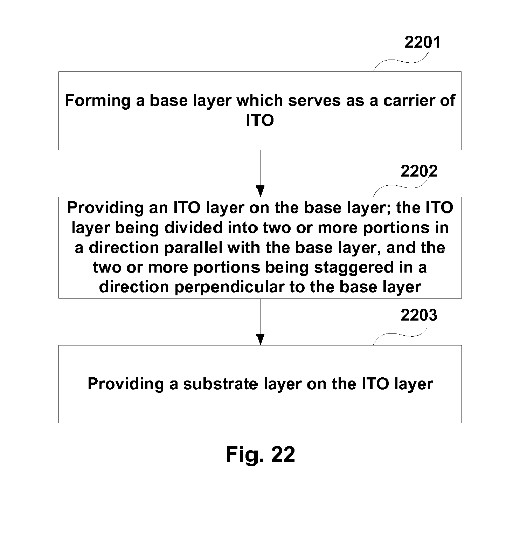

Fig. 22 is flowchart of a method for manufacturing a touch sensing component according to an embodiment of the present invention. As illustrated in Fig. 22, the method for manufacturing includes:
Step 2201: forming a base layer which serves as a carrier of ITO;
Step 2202: providing an ITO layer on the base layer; the ITO layer being divided into two or more portions in a direction parallel with the base layer, and the two or more portions being staggered in a direction perpendicular to the base layer.

As illustrated in Fig. 22, the method for manufacturing further includes:
Step 2203: providing a substrate layer on the ITO layer.

In this embodiment, the base layer may be made of a material such as film or glass, and the substrate layer may be made of toughened glass or transparent plastic, but the present invention is not limited thereto, and other materials may also be used according to actual conditions.

In this embodiment, for the formations of the base layer, the ITO layer and the substrate layer, please refer to the prior art, where the prior art may also be referred to for the signal connection between the two or more staggered portions of the ITO layer.

In this embodiment, the two or more portions are located in different planes in the direction parallel with the base layer.

In one embodiment, the ITO layer includes a first ITO layer provided on one surface of the base layer, and a second ITO layer provided on the other surface of the base layer. In addition, the first ITO layer is provided on a part of one surface of the base layer, and the second ITO layer is provided on a part of the other surface of the base layer, so that the first ITO layer and the second ITO layer are staggered in the direction perpendicular to the base layer.

In another embodiment, the base layer includes a first base layer and a second base layer, while the ITO layer includes a first ITO layer provided on the first base layer and a second ITO layer provided on the second base layer. In addition, the first ITO layer is provided on a part of the first base layer, and the second ITO layer is provided on a part of the second base layer, so that the first ITO layer and the second ITO layer are staggered in the direction perpendicular to the base layer.

In another embodiment, the touch sensing component includes a first ITO layer provided on one surface of the first base layer, and a second ITO layer provided on the other surface of the first base layer. In addition, the touch sensing component further includes a third base layer and a third ITO layer provided thereon.

In addition, the first ITO layer is provided on a part of one surface of the first base layer, and the second ITO layer is provided on a part of the other surface of the first base layer, so that the first ITO layer and the second ITO layer are staggered in the direction perpendicular to the base layer.

In another embodiment, the touch sensing component includes a first base layer, a second base layer, a first ITO layer provided on the first base layer, and a second ITO layer provided on the second base layer. In addition, the touch sensing component further includes a third base layer and a third ITO layer provided thereon.

In addition, the first ITO layer is provided on a part of the first base layer, and the second ITO layer is provided on a part of the second base layer, so that the first ITO layer and the second ITO layer are staggered in the direction perpendicular to the base layer.

As can be seen from the above embodiment, by staggering the ITO layer into two or more portions, the border size of the electronic device can be further reduced, and a larger effective display or control area can be obtained.

### Embodiment 4

The embodiment of the present invention provides a touch screen, which includes the touch sensing component as described in Embodiment 1 or 2. To be noted, the touch screen may include other components such as touch screen controller, please refer to the prior art.

The embodiment of the present invention further provides an electronic device, which includes the aforementioned touch screen. The electronic device may be a mobile terminal, but the present invention is not limited thereto.

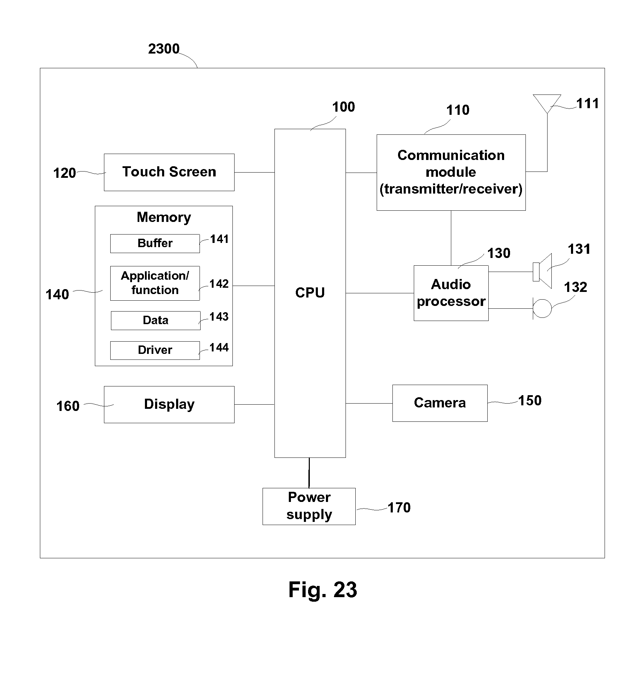

Fig. 23 is a schematic block diagram of a system structure of a mobile terminal 2300 according to an embodiment of the present invention, including a touch screen 120 which may be as described in Embodiment 1 or 2.

As illustrated in Fig. 23, the mobile terminal 2300 may further include a Central Processing Unit (CPU) 100, a communication module 110, an input unit 120, an audio processing unit 130, a memory 140, a camera 150, a display 160 and a power supply 170.

The CPU 100 (sometimes is referred to as controller or operation control, including microprocessor or other processor unit and/or logic unit) receives an input and controls respective parts and the operation of the mobile terminal 2300. The input unit 120 provides an input to the CPU 100. The camera 150 acquires image data and provides the acquired image data to the CPU 100 for a conventional usage, such as storage, transmission, etc.

The power supply 170 supplies electric power to the mobile terminal 2300. The display 160 displays an object to be displayed, such as image and text. The display 160 for example may be, but not limited to, an LCD display.

The memory 140 is coupled to the CPU 100. The memory 140 may be a solid-state memory such as Read Only Memory (ROM), Random Access Memory (RAM), Subscriber Identity Module (SIM) card, etc. It may also be such a memory which stores information even if the power is off, and which can be selectively erased and provided with more data. The example of the memory sometimes is referred to as EPROM. The memory 140 may also be other type of device. The memory 140 includes a buffer memory 141 (sometimes is referred to as buffer). The memory 140 may include an application/function storage section 142 configured to store application programs and function programs, or to perform procedures of the operation of the mobile terminal 2300 through the CPU 100.

The memory 140 may further include a data storage section 143 configured to store data such as contact, digital data, picture, sound and/or any other data used by the electronic device. A drive program storage section 144 of the memory 140 may include various drive programs of the electronic device for performing the communication function and/or other functions (e.g., message transfer application, address book application, etc.) of the electronic device.

The communication module 110 is a transmitter/receiver 110 which transmits and receives signals via an antenna 111. The communication module (transmitter/receiver) 110 is coupled to the CPU 100, so as to provide an input signal and receive an output signal, which may be the same as the situation of conventional mobile communication terminal.

Based on different communication technologies, the same electronic device may be provided with a plurality of communication modules 110, such as cellular network module, Bluetooth module and/or wireless local area network (WLAN) module. The communication module (transmitter/receiver) 110 is further coupled to a speaker 131 and a microphone 132 via an audio processor 130, so as to provide an audio output via the speaker 131, and receive an audio input from the microphone 132, thereby performing the normal telecom function. The audio processor 130 may include any suitable buffer, decoder, amplifier, etc. In addition, the audio processor 130 is further coupled to the CPU 100, so as to locally record sound through the microphone 132, and play the locally stored sound through the speaker 131.

The preferred embodiments of the present invention are described as above with reference to the drawings. Many features and advantages of those embodiments are apparent from the detailed Specification, thus the accompanied claims intend to cover all such features and advantages of those embodiments which fall within the true spirit and scope thereof. In addition, since numerous modifications and changes may be easily conceivable to a person skilled in the art, the embodiments of the present invention are not limited to the exact structure and operation as illustrated and described, but cover all suitable modifications and equivalents falling within the scope thereof.

It shall be understood that each of the parts of the present invention may be implemented by hardware, software, firmware, or combinations thereof. In the above embodiments, multiple steps or methods may be implemented by software or firmware that is stored in the memory and executed by an appropriate instruction executing system. For example, if the implementation uses hardware, it may be realized by any one of the following technologies known in the art or a combination thereof as in another embodiment: a discrete logic circuit having a logic gate circuit for realizing logic functions of data signals, application-specific integrated circuit having an appropriate combined logic gate circuit, a programmable gate array (PGA), and a field programmable gate array (FPGA), etc.

The description or blocks in the flowcharts or of any process or method in other manners may be understood as being indicative of comprising one or more modules, segments or parts for realizing the codes of executable instructions of the steps in specific logic functions or processes, and that the scope of the preferred embodiments of the present invention comprise other implementations, wherein the functions may be executed in manners different from those shown or discussed, including executing the functions according to the related functions in a substantially simultaneous manner or in a reverse order, which shall be understood by a person skilled in the art to which the present invention pertains.

The logic and/or steps shown in the flowcharts or described in other manners here may be, for example, understood as a sequencing list of executable instructions for realizing logic functions, which may be implemented in any computer readable medium, for use by an instruction executing system, apparatus or device (such as a system based on a computer, a system including a processor, or other systems capable of extracting instructions from an instruction executing system, apparatus or device and executing the instructions), or for use in combination with the instruction executing system, apparatus or device.

The above literal description and drawings show various features of the present invention. It shall be understood that a person of ordinary skill in the art may prepare suitable computer codes to carry out each of the steps and processes described above and illustrated in the drawings. It shall also be understood that the above-described terminals, computers, servers, and networks, etc. may be any type, and the computer codes may be prepared according to the disclosure contained herein to carry out the present invention by using the apparatuses.

Specific embodiments of the present invention have been disclosed herein. Those skilled in the art will readily recognize that the present invention is applicable in other environments. In practice, there exist many embodiments and implementations. The appended claims are by no means intended to limit the scope of the present invention to the above particular embodiments. Furthermore, any reference to "an apparatus configured to..." is an explanation of apparatus plus function for describing elements and claims, and it is not desired that any element using no reference to "an apparatus configured to ..." is understood as an element of apparatus plus function, even though the wording of "apparatus" is included in that claim.

Although a particular preferred embodiment or embodiments have been shown and the present invention has been described, it is obvious that equivalent modifications and variants are conceivable to a person skilled in the art in reading and understanding the description and drawings. Especially for various functions executed by the above elements (portions, assemblies, apparatus, and compositions, etc.), except otherwise specified, it is desirable that the terms (including the reference to "apparatus") describing these elements correspond to any element executing particular functions of these elements (i.e. functional equivalents), even though the element is different from that executing the function of an exemplary embodiment or embodiments illustrated in the present invention with respect to structure. Furthermore, although the a particular feature of the present invention is described with respect to only one or more of the illustrated embodiments, such a feature may be combined with one or more other features of other embodiments as desired and in consideration of advantageous aspects of any given or particular application.

## Claims

1. A touch sensing component, comprising:
a base layer which serves as a carrier of Indium Tin Oxide (ITO); and
an ITO layer provided on the base layer, the ITO layer being divided into two or more portions in a direction parallel with the base layer, wherein the two or more portions are staggered in a direction perpendicular to the base layer.

2. The touch sensing component according to claim 1, wherein the two or more portions are located in different planes in the direction parallel with the base layer.

3. The touch sensing component according to any one of the preceding claims, wherein the ITO layer comprises a first ITO layer provided on one surface of the base layer, and a second ITO layer provided on the other surface of the base layer, wherein
the first ITO layer is provided on a part of the one surface of the base layer, and
the second ITO layer is provided on a part of said the other surface of the base layer, such that the first ITO layer and the second ITO layer are staggered in the direction perpendicular to the base layer.

4. The touch sensing component according to any one of the preceding claims, wherein the base layer comprises a first base layer and a second base layer; and the ITO layer comprises a first ITO layer provided on the first base layer and a second ITO layer provided on the second base layer, wherein
the first ITO layer is provided on a part of the first base layer, and
the second ITO layer is provided on a part of the second base layer, such that the first ITO layer and the second ITO layer are staggered in the direction perpendicular to the base layer.

5. The touch sensing component according to claim 4, wherein the first base layer is provided on the second base layer.

6. The touch sensing component according to any one of claims 3-5, further comprising a substrate layer provided on the first ITO layer.

7. The touch sensing component according to any one of claims 3-6, further comprising: a third base layer provided on the first ITO layer and a third ITO layer provided on the third base layer.

8. The touch sensing component according to claim 7, further comprising a substrate layer provided on the third ITO layer.

9. A touch screen comprising the touch sensing component according to any one of the preceding claims.

10. An electronic device comprising the touch screen according to claim 9.

11. A method for manufacturing a touch sensing component, comprising:
forming a base layer which serves as a carrier of ITO; and
providing an ITO layer on the base layer wherein the ITO layer is divided into two or more portions in a direction parallel with the base layer, and the two or more portions are staggered in a direction perpendicular to the base layer.

12. The method for manufacturing according to claim 11, further comprising providing a substrate layer on the ITO layer.
